# EUROPÄISCHE PATENTSCHRIFT

(11) **EP 1 340 244 B1**
(45) Veröffentlichungstag und Bekanntmachung des Hinweises auf die Patenterteilung: **07.03.2007**
(21) Anmeldenummer: 01990451.5
(22) Anmeldetag: 28.11.2001
(51) Int. Cl.: H01L 21/00

(54) **VERFAHREN ZUM THERMISCHEN BEHANDELN VON SUBSTRATEN**
METHOD FOR THERMALLY TREATING SUBSTRATES
PROCEDE DE TRAITEMENT THERMIQUE DE SUBSTRATS

(30) Priorität: 01.12.2000 DE 10059665
(43) Veröffentlichungstag der Anmeldung: 03.09.2003
(73) Patentinhaber: HamaTech APE GmbH & Co. KG, 75447 Sternenfels (DE)
(72) Erfinder: SZEKERESCH, Jakob, 75328 Schönberg (DE); DRESS, Peter, 76646 Bruchsal (DE); DIETZE, Uwe, Austin, TX 78734 (US); SAULE, Werner, c/o Steag HamaTech AG, 75447 Sternenfels (DE)
(74) Vertreter: Wagner & Geyer
(86) Internationale Anmeldenummer: PCT/EP2001/013905
(87) Internationale Veröffentlichungsnummer: WO 2002/045135

(56) Entgegenhaltungen:
- WO-A-00/01628
- WO-A-00/51170
- WO-A-99/23690
- US-A- 5 650 082
- US-A- 5 740 016
- US-A- 5 790 750

## Beschreibung

Die vorliegende Erfindung bezieht sich auf ein Verfahren zum thermischen Behandeln von Substraten, bei dem das Substrat über eine Vielzahl von separat ansteuerbaren Heizelementen beheizt wird.

Derartige Vorrichtungen werden beispielsweise im Bereich der Halbleiterindustrie im Anschluß an Belackungsvorgänge von Substraten, insbesondere Fotomasken, verwendet, um die Substrate zur Aushärtung und chemischen Vorbehandlung der Schichten thermisch zu behandeln. Bei der thermischen Behandlung ist es für die nachfolgende Verwendbarkeit der Substrate wichtig, daß die aufgebrachten Schichten möglichst gleichmäßig und homogen behandelt werden. Dabei tritt jedoch das Problem auf, daß bei gleichmäßiger Ansteuerung der Heizelemente aufgrund von Randeffekten die Substrate nicht gleichmäßig behandelt werden können. Daher ist es bekannt, die Heizelemente im Randbereich der Substrate zu Beginn der thermischen Behandlung weniger stark zu beheizen, da im Mittelbereich zunächst eine vergleichbar größere Masse erwärmt werden muß. Später werden die Heizelemente im Randbereich der Substrate aufgrund der erhöhten thermischen Abstrahlung in diesen Bereichen stärker beheizt.

Aus der auf dieselbe Anmelderin zurückgehenden DE-A-199 07 497 ist eine Vorrichtung und ein Verfahren zum thermischen Behandeln von Substraten angegeben, bei dem eine Vielzahl von separat ansteuerbaren Heizelementen zunächst eine Heizplatte und dann ein darauf aufliegendes Substrat beheizt. Die einzelnen Heizelemente werden jeweils über einen PID-Regler geregelt, wobei der notwendige Sollwert in Form eines Sollwert-Profils vorgegeben wird. Als Sollwert-Profil ist hier die sich zeitlich, insbesondere in Zeitintervallen, verändernde Vorgabe von Sollwerten zu verstehen.

Während eines Behandlungsvorgangs wird die Temperaturverteilung auf der von der Heizplatte abgewandten Oberfläche des Substrats ermittelt und in Abhängigkeit von der Temperaturverteilung auf der Substratoberfläche gegenüber dem Sollwert-Profil geänderte Sollwerte für die einzelnen Heizelemente bestimmt und an die jeweiligen PID-Regler weitergeleitet. Hierdurch ergibt sich die Möglichkeit, während des Behandlungsvorgangs Korrekturen der Sollwert-Profile vorzunehmen, um eine verbesserte Temperaturhomogenität über die Substratoberfläche hinweg zu erreichen.

Bei diesem Verfahren ergibt sich jedoch das Problem, daß das Verfahren immer nur auf schon aufgetretene Temperaturinhomogenitäten auf der Substratoberfläche reagieren kann, um diese über eine Veränderung des Sollwert-Profils der einzelnen Heizelemente nachträglich zu korrigieren. Ein Vorausschauen auf zukünftige, während der Behandlung auftretende Temperaturinhomogenitäten ist nicht möglich. Auch werden die bei einer Behandlung auftretenden Probleme, wie beispielsweise eine erhöhte Temperaturinhomogenität bei einem bestimmen Temperaturwert, bei der Behandlung des nächsten Substrats nicht berücksichtigt, da den einzelnen Heizelementen wiederum das zuvor festgelegte Sollwert-Profil vorgegeben wird. Daher ist zu erwarten, daß bei der nächsten Behandlung dieselben Probleme wie bei der vorhergehenden Behandlung auftreten.

Ausgehend von diesem bekannten Stand der Technik liegt der vorliegenden Erfindung daher die Aufgabe zugrunde, ein Verfahren zum thermischen Behandeln von Substraten zu schaffen, das eine selbstoptimierende Prozeßsteuerung ermöglicht, um die Temperaturhomogenität auf der Oberfläche eines zu behandelnden Substrats zu erhöhen.

Erfindungsgemäß wird die gestellte Aufgabe bei einem Verfahren zum thermischen Behandeln von Substraten gemäß dem Anspruch 1, bei dem das Substrat über eine Vielzahl von separat ansteuerbaren Heizelementen beheizt wird, denen jeweils ein Sollwert-Profil vorgegeben wird, durch ortsaufgelöstes Messen der Temperatur der von den Heizelementen abgewandten Oberfläche des Substrats wäh-rend der thermischen Behandlung, Ermitteln von auf der Substratoberfläche auftretenden Temperaturinhomogenitäten, Bestimmen neuer Sollwert-Profile auf der Grundlage der ermittelten Temperaturinhomogenitäten und Bereitstellen der neuen Sollwert-Profile für nachfolgende Behandlungsvorgänge gelöst. Dieses Verfahren ermöglicht eine selbstoptimierende Prozeßsteuerung, da die den einzelnen Heizelementen vorgegebenen Sollwert-Profile neu bestimmt und für nachfolgende Behandlungsvorgänge bereitgestellt werden, so daß während der thermischen Behandlung aufgetretene Temperaturinhomogenitäten bei der Bestimmung der neuen Sollwert-Profile berücksichtigt und somit bei der nächsten Behandlung verhindert werden. Hierdurch ergibt sich eine Selbstoptimierung des Sollwert-Profils und somit eine homogenere thermische Behandlung der Substrate.

Gemäß einer besonders bevorzugten Ausführungsform wird eine während der thermischen Behandlung auftretende Temperaturinhomogenität bei der Bestimmung der neuen Sollwert-Profile zeitlich vorauseilend berücksichtigt. Bei der Bestimmung der neuen Sollwert-Profile können Sprünge hinsichtlich der Homogenität, die beispielsweise bei einer bestimmten Temperatur bzw. zu einem bestimmten Zeitpunkt in der Behandlung auftreten, vor Erreichen dieser Temperatur bzw. vor dem jeweiligen Zeitpunkt berücksichtigt werden, so daß diesen Temperaturinhomogenitäten schon bei niedrigeren Temperaturen bzw. zu früheren Zeitpunkten entgegengewirkt werden kann. Somit kann schon vor ihrem Auftreten damit begonnen werden, die ermittelten Temperaturinhomogenitäten auszugleichen. Diese antizipatorische Berücksichtigung von zu bestimmten Zeitpunkten bzw. bei bestimmten Temperaturen auftretenden Inhomogenitäten ermöglichen eine stark verbesserte Temperaturhomogenität während der Behandlung.

Vorzugsweise wird die Temperatur der Substratoberfläche an vorgegebenen Oberflächenpunkten ermittelt, um die benötigte Rechenleistung gegenüber Systemen, bei denen alle Oberflächenpunkte berücksichtigt werden, zu verringern. Um die Genauigkeit des Verfahrens zu erhöhen, wird den Oberflächenpunkten der Mittelwert aller Temperaturmeßwerte auf einem dem Oberflächenpunkt zugeordneten Oberflächenbereich zugewiesen. Dabei bleibt die Zuordnung der Oberflächenbereiche zu den Oberflächenpunkten während wenigstens eines Meßzyklus konstant, um über den Meßzyklus hinweg gleichmäßige Ergebnisse zu erhalten.

Bei einer besonders bevorzugten Ausführungsform erfolgt die Bestimmung des neuen Sollwert-Profils anhand einer gewichteten Zuordnung der Oberflächenpunkte zu den einzelnen Heizelementen, wodurch der unterschiedliche Einfluß der Heizelemente zu den unterschiedlichen Oberflächenpunkten berücksichtigt wird. Um innerhalb eines Meßzyklus gleichmäßige Ergebnisse zu erhalten, bleibt die gewichtete Zuordnung der einzelnen Heizelemente zu den Oberflächenpunkten während wenigstens eines Meßzyklus konstant. Die gewichtete Zuordnung der einzelnen Heizelemente zu den Oberflächenpunkten kann jedoch bei der Bestimmung des neuen Sollwert-Profils geändert werden, um auch hinsichtlich der Zuordnung eine Optimierung zu erreichen.

Die Sollwert-Profile sehen Sollwert-Änderungen in bestimmten Zeitintervallen vor, um ein bestimmtes Heizprofil zu erzeugen. Um eine verbesserte Anpassung des Sollwert-Profils zu ermöglichen, werden bei der Bestimmung der neuen Sollwert-Profile die Zeitintervalle für die Sollwert-Änderungen vorzugsweise neu gewählt.

Vorzugsweise erfolgt eine neue Bestimmung des Sollwert-Profils nur dann, wenn Temperaturinhomogenitäten über einem vorgegebenen Schwellenwert auftreten, da bei Temperaturinhomogenitäten unterhalb des Schwellenwerts von einem optimierten System ausgegangen wird, in das möglichst nicht mehr eingegriffen wird. Vorzugsweise liegt das Substrat während der thermischen Behandlung auf einer zwischen den Heizelementen und dem Substrat angeordneten Platte auf.

Die erfindungsgemäße Aufgabe wird auch bei einem Verfahren zum Optimieren von Sollwert-Profilen einer Vielzahl von separat ansteuerbaren Heizelementen zum thermischen Behandeln von Substraten gelöst, wobei die Heizelemente anhand jeweils vorgegebener Sollwert-Profile erwärmt werden, die Temperatur der von den Heizelementen abgewandten Oberfläche des Substrats während der Erwärmung ortaufgelöst gemessen und auf der Substratoberfläche auftretende Temperaturinhomogenitäten zeitabhängig ermittelt werden, wobei neue Sollwert-Profile auf der Grundlage der Temperaturinhomogenitäten während des Behandlungsvorgangs bestimmt und für einen nachfolgenden Erwärmungsvorgang verwendet werden und wobei die vorhergehenden Schritte wiederholt werden, bis die Temperaturinhomogenitäten zu jedem Zeitpunkt der Erwärmung unter einem vorbestimmten Schwellenwert liegen. Hierdurch läßt sich, wie schon oben ausgeführt, ein optimiertes Sollwert-Profil festlegen.

Vorzugsweise wird das erfindungsgemäße Verfahren bei Fotomasken eingesetzt.

Die Erfindung wird nachfolgend anhand eines bevorzugten Ausführungsbeispiels unter Bezugnahme auf die Zeichnungen erläutert; in den Zeichnungen zeigt:
- Fig. 1: eine schematische Seitenansicht eines Systems zur thermischen Behandlung von Substraten gemäß der Erfindung;
- Fig. 2a: eine schematische Darstellung eines auf einer Heizplatte angeordneten Substrats;
- Fig. 2b: eine Tabelle, die den Einfluß einzelner Heizelemente bezüglich bestimmter Oberflächenpunkte auf dem Substrat zeigt;
- Fig. 3: eine Darstellung der zeitlichen Änderung der örtlichen Sollwert-Verteilung für einzelne Zonen einer zonengesteuerten Heizplatte (5 x 5 Heizzonen) im Verlauf einer thermischen Behandlung eines Substrats;
- Fig. 4a: eine Tabelle einer Sollwert-Verteilung für Zonen einer Heizplatte, bei einer thermischen Behandlung mit einer Endtemperatur von 110°C für ein Substrat;
- Fig. 4b: eine graphische Darstellung eines solchen Sollwert-Profils;
- Fig. 5: eine schematische Darstellung eines Iterationszyklus für eine automatisierte Optimierung eines vorgegebenen Sollwert-Profils.

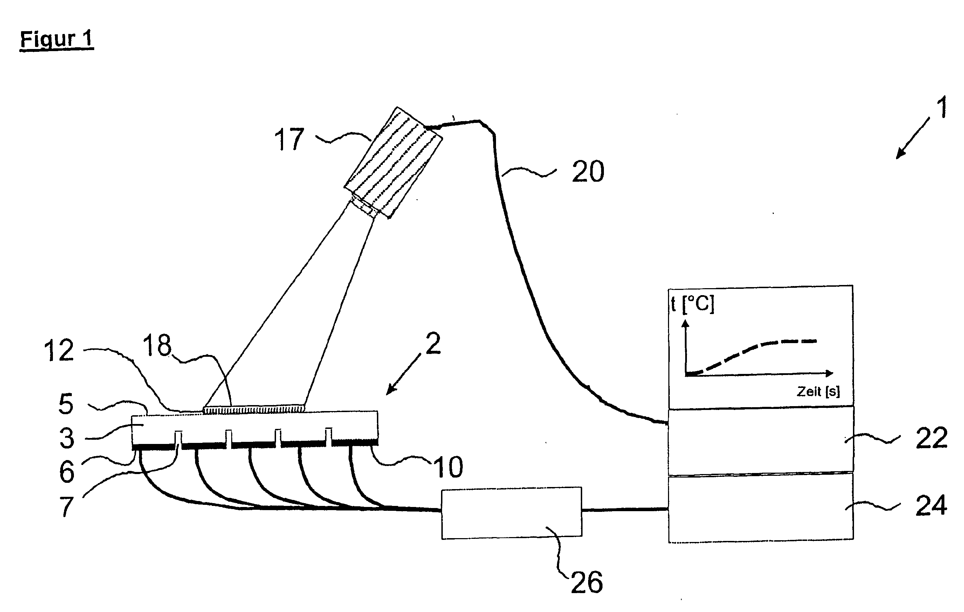

Fig. 1 zeigt eine schematische Seitenansicht einer Vorrichtung 1 zum thermischen Behandeln von Substraten.

Die Vorrichtung 1 weist eine zonengesteuerte Heizplatte 2 auf, die aus einer quadratischen Grundplatte 3 mit im wesentlichen rechteckigem Querschnitt besteht. Die Grundplatte 3 besitzt eine erste ebene Oberseite 5 und eine segmentierte Unterseite 6. Die Unterseite 6 wird durch jeweils vier sich senkrecht zu den Seitenkanten der Heizplatte erstreckenden Nuten 7 in insgesamt 25 quadratische Segmente 8 aufgeteilt. Die Tiefe der Nuten 7 entspricht ungefähr der halben Dicke der Grundplatte 3. Auf den quadratischen Segmenten 8 der Heizplatte 2 sind jeweils quadratische Heizelemente 10 angeordnet, die in geeigneter Weise, wie z. B. durch Verkleben mit den Segmenten 8 der Grundplatte 3 verbunden sind, und mit ihnen entsprechende Heizzonen bilden. Durch die Anordnung der Heizelemente 10 auf den jeweils durch die Nuten 7 getrennten Segmenten 8 sind sie thermisch voneinander getrennt, so daß sie sich nicht gegenseitig beeinflussen, d. h. daß kein wesentliches thermisches Übersprechen zwischen den Heizelementen auftritt. Über die Grundplatte 3 sind die Heizelemente 10 jedoch ausreichend thermisch miteinander gekoppelt, so daß auf der Oberseite 5 der Grundplatte 3 eine homogene Temperaturverteilung ohne eine thermische Ausprägung der einzelnen Heizelemente im thermischen Bild der Oberseite 5 erreicht wird. Jedem Heizelement 10 ist ein nicht gezeigter Temperatursensor in der Form eines Thermoelements zugeordnet, der die Ist-Temperatur der Heizelemente 10 mißt. Anstelle der Thermoelemente ist auch die Verwendung anderer, z. B. optischer Temperatursensoren möglich.

Obwohl die Heizplatte 2 als eine einteilige Grundplatte 3 mit darin ausgebildeten Nuten 7 zur Segmentierung der Oberseite 6 der Grundplatte 3 beschrieben wurde, sei bemerkt, daß die Grundplatte 3 vollständig eben ausgebildet sein kann, und die Heizelemente 10 direkt oder über Abstandselemente mit der Grundplatte 3 verbunden sind. In gleicher Weise ist die Erfindung nicht auf die Form und Anzahl der Segmente 8 und der Heizelemente 10 beschränkt.

Die ebene Oberseite 5 der Grundplatte 3 der Heizplatte 1 ist benachbart zu einem zu behandelnden Substrat 12, z. B. mit einem Abstand zwischen 0,1 und 0,5 mm angeordnet. Das Substrat wird beispielsweise auf vier nicht dargestellten Halterungen über der Heizplatte 1 gehalten. Oberhalb der Heizplatte 1 und des Substrats 12 ist eine Temperaturmeßvorrichtung 17 in der Form einer Infrarotkamera angeordnet. Die Infrarotkamera 17 ist auf eine von der Heizplatte 1 abgewandte Oberseite 18 des Substrats 12 gerichtet. Die Infrarotkamera 17 beinhaltet eine nicht näher dargestellte Scan-Vorrichtung mit einem bewegbaren Spiegel, über den sequentiell die gesamte Oberfläche 18 des Substrats 12 abgetastet wird. Über die Scan-Vorrichtung wird ein ortsaufgelöstes Bild der Temperaturverteilung der Oberseite 18 des Substrats 12 erzeugt, wobei die gesamte Oberfläche beispielsweise einmal pro Sekunde abgetastet wird.

Die Infrarotkamera 17 ist über eine Datenleitung 20 mit einer Rechnereinheit in der Form eines PC's 22 verbunden. Innerhalb des PC's werden die von der IR-Kamera erhaltenen Meßwerte verarbeitet und eine räumliche Temperaturverteilung auf der Oberfläche 18 des Substrats ermittelt, und, wie nachfolgend noch näher erläutert wird, verarbeitet.

In Fig. 1 ist ferner eine Prozeßsteuerung 24, sowie ein PID-Regler 26 zu sehen, der mit den einzelnen Heizelementen 10 und den nicht dargestellten Temperatursensoren verbunden ist und mit diesen einen Regelkreis bildet. Der PID-Regler regelt die Heizleistung der einzelnen Heizelemente 10 anhand eines durch die Prozeßsteuerung vorgegebenen Sollwert-Profils, d. h. einer Reihe von sich zeitlich verändernden Temperatur-Sollwerten, insbesondere Zeitintervallen, und der durch die Temperatursensoren gemessenen Temperatur-Ist-Werte.

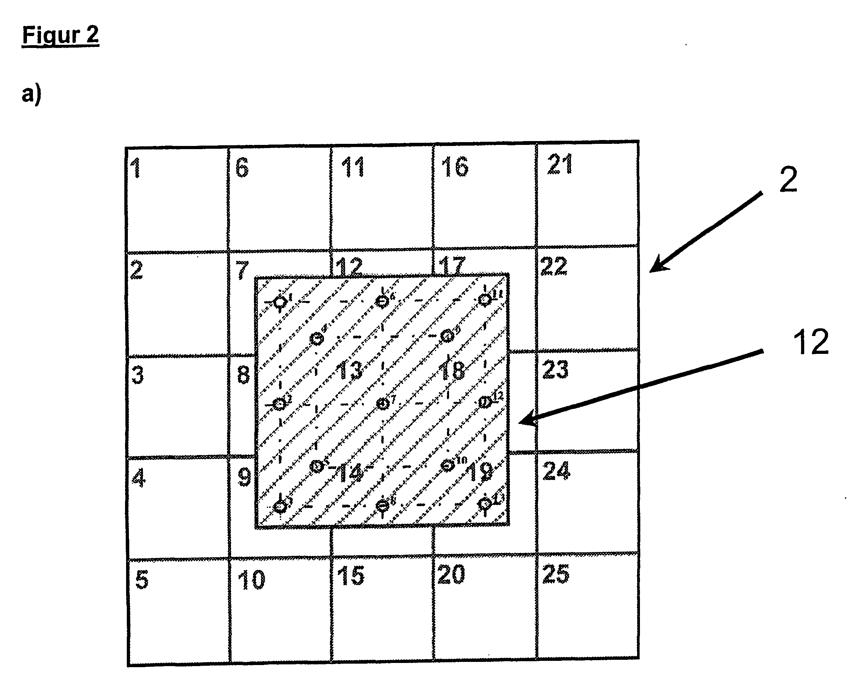

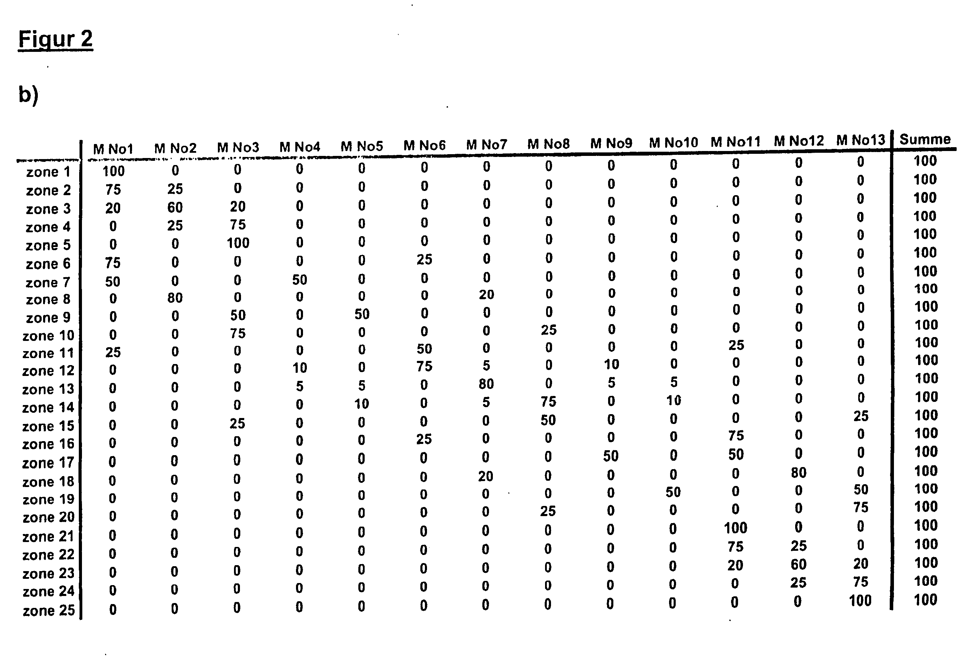

Fig. 2 zeigt eine schematische Draufsicht auf die Heizplatte 1 mit einem darauf aufliegenden Substrat 12, wie beispielsweise einer Fotomaske. Die durch die Heizelemente 10 und die Segmente 8 gebildeten Heizzonen sind schematisch angedeutet und von 1 bis 25 numeriert. Auf dem Substrat 12 sind Oberflächenpunkte 1 bis 13 angezeigt, die, wie nachfolgend noch näher beschrieben wird, als Zuordnungspunkte verwendet werden.

Wie in der schematischen Draufsicht gemäß Fig. 2 zu erkennen ist, deckt das Substrat die mittleren neun der insgesamt 25 Heizzonen der Heizplatte 2 ab. Daher sind bei einer thermischen Behandlung des Substrats hauptsächlich diese neun Zonen beteiligt, obwohl auch die restlichen Zonen einen Einfluß auf die thermische Behandlung besitzen.

Die Tabelle gemäß Fig. 2b zeigt eine Zuordnung der einzelnen Heizzonen zu den Oberflächenpunkten auf dem Substrat. Die in Fig. 2 angegebene Zuordnung und Gewichtung ist nicht exakt und soll lediglich das Prinzip einer Gewichtung darstellen. Beispielsweise beeinflußt die von der Heizzone 1 stammende, das Substrat 12 erreichende Heizleistung ausschließlich die Temperatur des Substrats 12 im Bereich des Oberflächenpunktes 1. Somit ist die Heizzone zu 100 % dem Oberflächenpunkt 1 zugeordnet. Im Gegensatz hierzu beeinflußt die von der Heizzone 2 stammende, das Substrat 12 erreichende Heizleistung sowohl die Temperatur des Substrats im Bereich des Oberflächenpunktes 1 als auch des Oberflächenpunktes 2. Dabei beeinflußt die von der Heizzone 2 ausgehende Wärme den Oberflächenpunkt 1 dreimal stärker als den Oberflächenpunkt 2. Somit ist die Heizzone 2 in einem Verhältnis von 75:25 den Oberflächenpunkten 1 und 2 zugeordnet. Die Tabelle 2b zeigt die Gewichtung für alle 25 Zonen der Heizplatte 1.

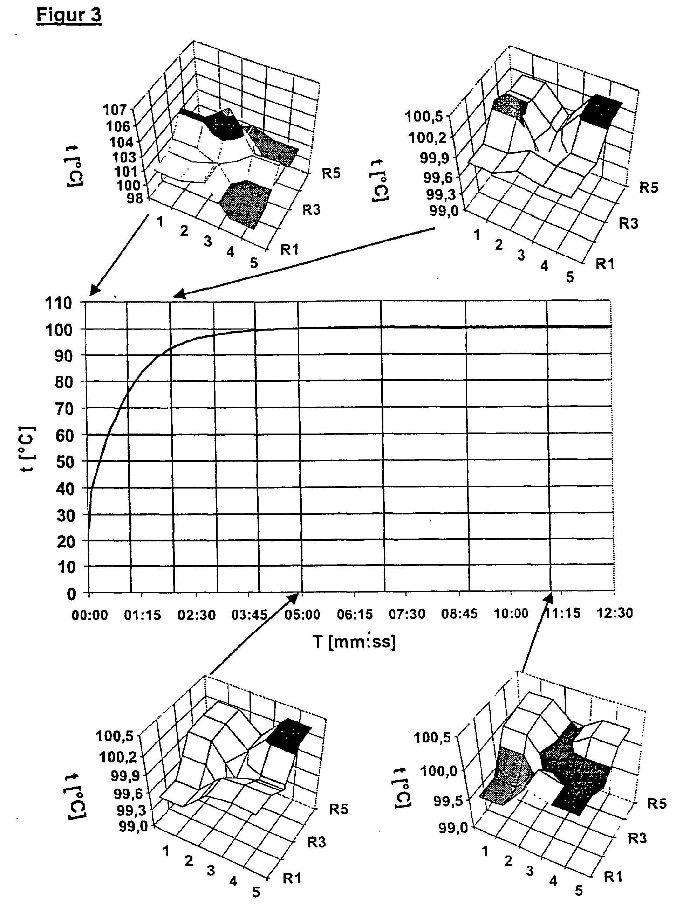

Fig. 3 zeigt vier Momentaufnahmen der zeitlichen Änderung einer örtlichen Sollwert-Verteilung für die einzelnen Zonen einer zonengesteuerten Heizplatte mit 5 x 5 Heizzonen im Verlauf einer thermischen Behandlung eines Substrats, die um eine mittlere Graphik gruppiert sind. Die mittlere Graphik zeigt die zeitliche Entwicklung des Mittelwerts der gemessenen Temperaturwerte auf der Substratoberfläche, wobei die senkrechten Linien die Zeitpunkte markieren, an denen die Sollwerte für die einzelnen Heizzonen verändert werden. Bei der mittleren Graphik zeigt die vertikale Achse die Temperatur t in °C, während die horizontale Achse die Zeit T in Minuten und Sekunden darstellt. Bei den vier Momentaufnahmen der örtlichen Sollwert-Vorgaben sind auf der vertikalen Achse die Soll-Temperatur der jeweiligen Heizzonen in °C angegeben. Die beiden anderen Achsen stellen das 5 x 5 Grundmuster der Heizzonen dar. Der oben links liegende Graph zeigt die Sollwert-Verteilung der einzelnen Zonen der Heizplatte 1 zu Beginn der thermischen Behandlung, d. h. in einem Zeitintervall von 0 Sekunden bis ungefähr 1 Minute. Der rechts daneben liegende Graph zeigt die Sollwert-Verteilung der zonengesteuerten Heizplatte zum Zeitpunkt von ungefähr 2 Minuten 5 Sekunden, die im dritten Zeitintervall von ungefähr 2 Minuten bis 3 Minuten beibehalten wird. Der unten links liegende Graph zeigt die Sollwert-Verteilung zum Zeitpunkt von ungefähr 5 Minuten für das sechste Zeitintervall und der rechts daneben liegende Graph die Sollwert-Verteilung in einem letzten Zeitintervall, das bei ungefähr 11 Minuten beginnt.

Wie bei dem Graph oben links zu erkennen ist, wird zu Beginn der thermischen Behandlung die mittlere Zone stärker erwärmt als die anderen Zonen, da in diesem Bereich zunächst eine vergleichsweise größere Masse erwärmt werden muß. Bei dem rechts daneben angeordneten Graph ist zu erkennen, daß die mittlere Zone weniger stark beheizt wird, was auf die größere Wärmeabstrahlung im Randbereich des Substrats zurückzuführen ist. In ähnlicher Weise ist auch bei den unten liegenden Graphen zu erkennen, daß die Randzonen der Heizplatte zumindest teilweise stärker erwärmt werden als die mittlere Zone.

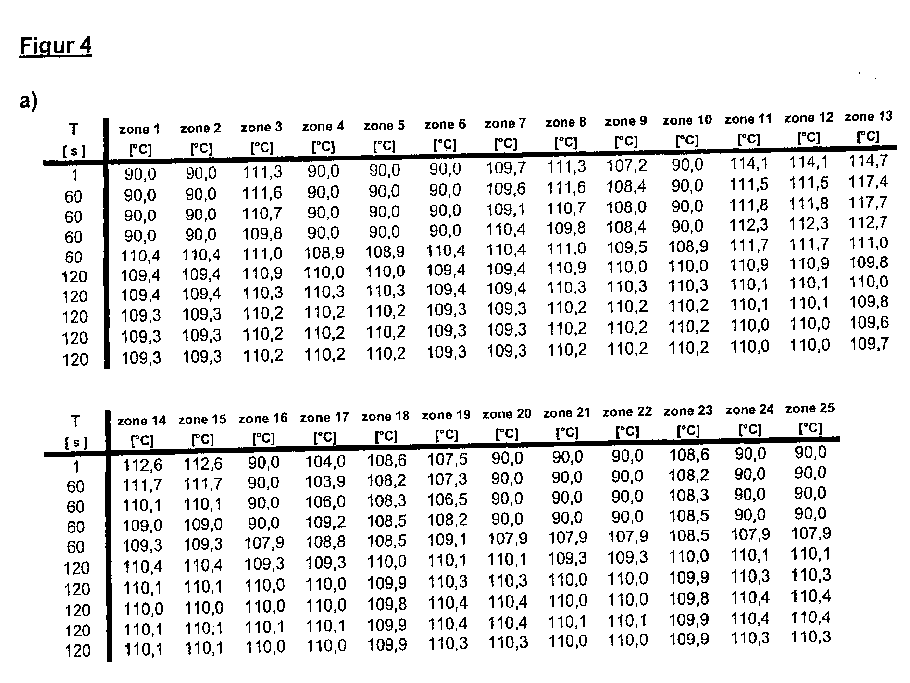

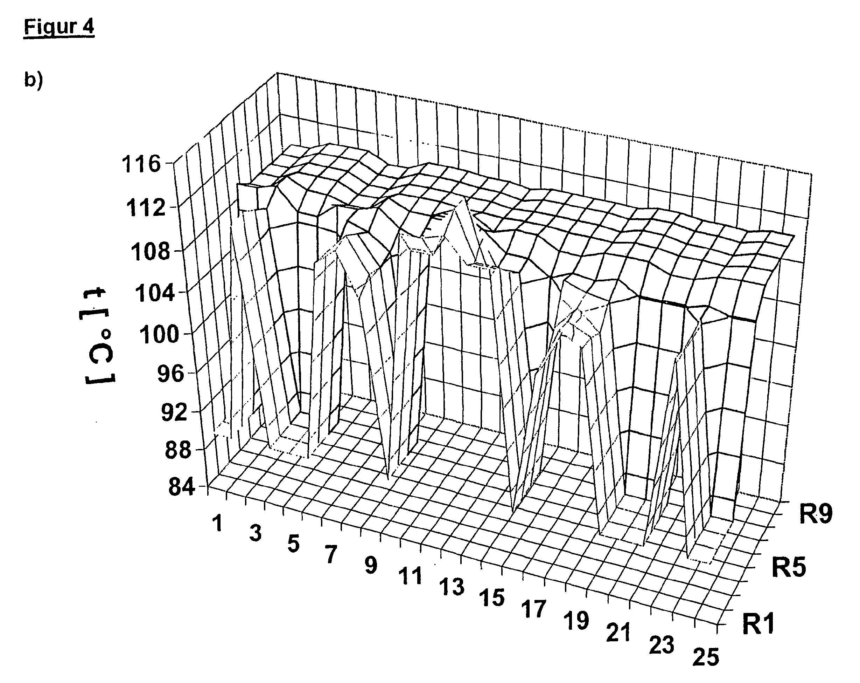

Die Fig. 4 zeigt ein typisches Profil für eine thermische Behandlung einer Maske, bei dem eine Endtemperatur von 110°C auf der Probenoberfläche erreicht werden soll. Dabei zeigt die Fig. 4a eine Tabelle für eine Sollwert-Verteilung für die Zonen der Heizplatte, wobei in der linken Spalte die Länge der einzelnen Zeitintervalle für den jeweiligen Temperaturschritt angegeben sind. Fig. 4b zeigt eine dreidimensionale graphische Veranschaulichung des Sollwert-Profils, wobei die vertikale Achse die Temperatur t in °C angibt, die im wesentlichen horizontal verlaufende Achse die Heizzonen 1 bis 25 anzeigt und die nach hinten verlaufende Achse die Zeitintervalle R1 bis R9 markiert. Aus dieser dreidimensionalen Darstellung ist deutlich die unterschiedliche Ansteuerung der jeweiligen Heizzonen 1 bis 25 zu erkennen, wobei zu Beginn der Behandlung die mittlere Heizzone am stärksten beheizt wird.

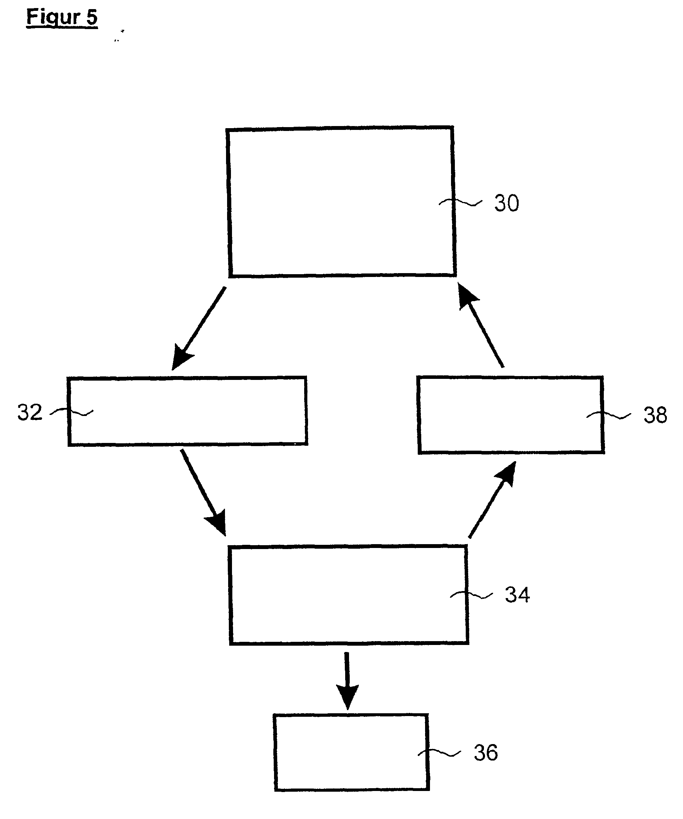

Fig. 5 zeigt einen Iterationszyklus, der bei einer automatisierten Optimierung eines Sollwert-Profils für die einzelnen Heizzonen der Heizplatte 1 verwendet wird. Im Block 30 beginnt ein Behandlungszyklus, bei dem den 25 Zonen der Heizplatte 1 jeweils ein bestimmtes Sollwert-Profil vorgegeben wird. Die zunächst verwendeten Sollwert-Profile können eine beliebige Form aufweisen, z. B. können sie alle gleich sein, oder sie können normalisierte Startprofile darstellen, wie nachfolgend erläutert wird. Die Sollwert-Profile sind für die thermische Behandlung eines bestimmten Substrats, sowie auf das Erreichen eines vorgegebenen Temperatur-Endwerts ausgelegt.

Während der thermischen Behandlung wird über die Infrarotkamera 17 die Temperatur auf der von den Heizelementen 10 abgewandten Oberfläche 18 des Substrats 12 gemessen und an die Rechnereinheit 22 weitergeleitet. In der Rechnereinheit 22 wird den zuvor genannten Oberflächenpunkten auf der Oberfläche des Substrats jeweils der Mittelwert aller Meßwerte aus einem dem Oberflächenpunkt zugeordneten Oberflächenbereich zugeordnet. Diese Zuordnung vereinfacht die nachfolgende Berechnung von neuen Sollwert-Profilen.

Im Block 34 wird zu jedem Zeitpunkt der thermischen Behandlung die Temperaturdifferenz zwischen den Oberflächenpunkten auf der Substratoberfläche festgestellt und mit einem vorgegebenen Schwellenwert verglichen. Wenn die Temperaturdifferenz zu jedem Zeitpunkt der thermischen Behandlung unter dem Schwellenwert liegt, geht die Prozeßsteuerung zum Block 36 über, der anzeigt, daß ein optimiertes Sollwert-Profil vorliegt und keine weitere Anpassung notwendig ist.

Wenn die Temperaturdifferenz jedoch zumindest zeitweise den Schwellenwert übersteigt, geht die Prozeßsteuerung zum Block 38 über, in dem die Sollwert-Profile für die einzelnen Heizelemente neu berechnet werden. Der dabei verwendete Algorithmus umfaßt eine gezielte und gewichtete Zuordnung der Oberflächenpunkte auf dem Substrat zu den Zonen der Heizfläche. Das neu berechnete Sollwert-Profil wird an den Startblock 30 übergeben und anstelle des vorhergehenden Start-Profils gesetzt. Mit diesem neu berechneten Sollwert-Profil wird nunmehr ein erneuter thermischer Behandlungsvorgang durchgeführt, während im Block 32 die Temperaturverteilung auf der Substratoberfläche gemessen wird. Dieser lterationszyklus wird solange wiederholt, bis die Temperaturdifferenz zwischen den Oberflächenpunkten auf der Substratoberfläche zu jedem Zeitpunkt unter den vorgegebenen Schwellenwert fällt. Zu diesem Zeitpunkt liegt ein optimiertes Sollwert-Profil vor, in das nicht mehr eingegriffen wird. Dieses optimierte Sollwert-Profil wird für nachfolgende thermische Behandlungsvorgänge mit den gleiche Parameter aufweisenden Substraten, die auf den selben Temperatur-Endwert erwärmt werden, verwendet.

Bei der Neuberechnung der Sollwert-Profile können nicht nur die Temperaturvorgaben während vorgegebener Zeitintervalle verändert werden. Vielmehr kann auch die Länge einzelner Zeitintervalle angepaßt werden.

Die Zuordnung der Oberflächenbereiche der Probe zu den Oberflächenpunkten bzw. die Zuordnung der Oberflächenpunkte zu den Zonen der Heizfläche lassen sich ebenfalls verändern.

Gemäß der bevorzugten Ausführungsform der Erfindung werden bei der Neuberechnung der Sollwert-Profile die zu einem bestimmten Zeitpunkt auftretenden Temperaturinhomogenitäten antizipatorisch berücksichtigt, um eine gleichmäßige und frühzeitige Anpassung des Profils zu erreichen. Wenn beispielsweise zu einem Zeitpunkt T = 50 Sekunden eine Temperaturinhomogenität an einem bestimmten Oberflächenpunkt auftritt, so wird bei dem neu berechneten Profil diese Inhomogenität schon zu einem früheren Zeitpunkt, z. B. T = 30 Sekunden berücksichtigt, indem das Sollwert-Profil wenigstens eines Heizelements so geändert wird, daß schon zu diesem Zeitpunkt eine lokal stärkere oder geringere Erwärmung erfolgt. Somit lassen sich die Temperaturinhomogenitäten ohne Temperatursprünge der Heizelemente und größere Sprünge bei der Sollwert-Vorgabe zwischen den einzelnen Intervallen erreichen.

Die oben genannte Optimierung muß für jedes unterschiedliche Substrat sowie für jeden Temperatur-Endwert durchgeführt werden. Zur Zeitersparnis bei der Ermittlung des idealen Sollwert-Profils für thermische Behandlungen mit verschiedenen Endtemperaturen wird zunächst ein normiertes Profil berechnet. Bei dieser Berechnung wird davon ausgegangen, daß das thermische Verhalten des Substrattyps bei unterschiedlichen Temperaturen im wesentlichen gleich ist. Daher wird das normierte Profil aus einem optimierten Profil dadurch gebildet, daß es durch den Temperatur-Endwert des optimierten Profils geteilt wird, um ein normiertes Profil zu erhalten. Für jede weitere gewünschte Endtemperatur wird nun das normierte Profil mit dem neuen Endwert multipliziert. Die so berechneten Sollwert-Profile werden dann als Startprofil bei dem Iterationszyklus gemäß Fig. 5 verwendet. Hierdurch läßt sich die Anzahl der Iterationszyklen vor Erreichen eines optimierten Prozeßprofils erheblich vermindern.

Derartig optimierte Profile können einem Kunden zur Verfügung gestellt werden, um dann beispielsweise in Kombination mit dem aus der DE-A-199 07 497 bekannten Verfahren verwendet zu werden, das insofern zum Gegenstand der vorliegenden Anmeldung gemacht wird, um Wiederholungen zu vermeiden. Alternativ kann der Optimierungszyklus auch beim Kunden erfolgen, so daß sich die Prozeßsteuerung über die Zeit hinweg automatisch selbst optimiert.

Die Erfindung wurde zuvor anhand eines bevorzugten Ausführungsbeispiels der Erfindung beschrieben, ohne jedoch auf die spezielle Ausführungsform beschränkt zu sein. Beispielsweise könnte die Heizplatte eine andere, wie z. B. eine runde Form, mit runden oder Kreissegmenten gebildeten Heizelementen aufweisen. Statt einer Infrarotkamera könnte auch eine andere, ortsauflösende Temperaturmeßvorrichtung verwendet werden.

## Patentansprüche

1. Verfahren zum Optimieren von Sollwert-Profilen einer Vielzahl von ansteuerbaren Heizelementen zum thermischen Behandeln von Substraten, bei dem das Substrat über eine Vielzahl von separat ansteuerbaren Heizelementen beheizt wird, denen jeweils ein Sollwert-Profil vorgegeben wird, mit folgenden Verfahrensschritten:
a. Erwärmen der Heizelemente anhand von jeweils vorgegebenen Sollwert-Profilen,
b. ortsaufgelöstes Messen der Temperatur der von den Heizelementen abgewandten Oberfläche des Substrats während eines thermischen Behandlungsvorgangs;
c. Ermitteln von auf der Substratoberfläche auftretenden Temperaturinhomogenitäten;
d. Bestimmen neuer Sollwert-Profile auf der Grundlage der ermittelten Temperaturinhomogenitäten; und
e. Bereitstellen der neuen Sollwert-Profile für nachfolgende Behandlungsvorgänge.

2. Verfahren nach Anspruch 1, **dadurch gekennzeichnet, daß** eine während der thermischen Behandlung auftretende Temperaturinhomogenität bei der Bestimmung der Sollwert-Profile zeitlich vorauseilend berücksichtigt wird.

3. Verfahren nach Anspruch 1 oder 2, **dadurch gekennzeichnet, daß** die Temperatur der Substratoberfläche an vorgegebenen Oberflächenpunkten ermittelt wird.

4. Verfahren nach Anspruch 3, **dadurch gekennzeichnet, daß** den Oberflächenpunkten der Mittelwert aller Temperaturmeßwerte aus einem dem Oberflächenpunkt zugeordneten Oberflächenbereich zugewiesen wird.

5. Verfahren nach Anspruch 3 oder 4, **dadurch gekennzeichnet, daß** die Zuordnung der Oberflächenbereiche zu den Oberflächenpunkten während wenigstens eines Meßzyklus konstant bleibt.

6. Verfahren nach einem der Ansprüche 3 bis 5, **dadurch gekennzeichnet, daß** die Bestimmung des neuen Sollwert-Profils anhand einer gewichteten Zuordnung der einzelnen Oberflächenpunkte zu den Heizelementen erfolgt.

7. Verfahren nach Anspruch 6, **dadurch gekennzeichnet, daß** die gewichtete Zuordnung während wenigstens eines Meßzyklus konstant bleibt.

8. Verfahren nach Anspruch 6 oder 7, **dadurch gekennzeichnet, daß** die gewichtete Zuordnung bei der Bestimmung des neuen Sollwert-Profils geändert wird.

9. Verfahren nach einem der vorhergehenden Ansprüche, **dadurch gekennzeichnet, daß** bei der Bestimmung der neuen Sollwert-Profile die Zeitintervalle für Sollwert-Änderungen neu gewählt werden.

10. Verfahren nach Anspruch einem der vorhergehenden Ansprüche, **dadurch gekennzeichnet, daß** eine neue Bestimmung des Sollwert-Profils nur dann erfolgt, wenn Temperaturinhomogenitäten über einem vorgegebenen Schwellenwert auftreten.

11. Verfahren nach einem der vorhergehenden Ansprüche, **dadurch gekennzeichnet, daß** das Substrat während der thermischen Behandlung auf einer zwischen den Heizelementen und dem Substrat angeordneten Platte aufliegt.

12. Verfahren nach einem der vorhergehenden Ansprüche, **dadurch gekennzeichnet, daß** als ursprüngliche Sollwert-Profile normierte Sollwert-Profile verwendet werden, die aus einem optimierten Sollwert-Profil berechnet wurden.

13. Verfahren zum Optimieren von Sollwert-Profilen einer Vielzahl von separat ansteuerbaren Heizelementen nach Anspruch 1 **gekennzeichnet durch** zum thermischen Behandeln von Substraten mit folgenden Verfahrensschritten das Wiederholen der Schritte a bis e, bis die Temperaturinhomogenitäten zu jedem Zeitpunkt der Erwärmung unter einem vorbestimmten Schwellenwert liegen.

14. Verfahren nach Anspruch 13, **dadurch gekennzeichnet, daß** die Optimierung für unterschiedliche Substrate und unterschiedliche Endtemperaturen der thermischen Behandlung durchgeführt werden.

15. Verfahren nach Anspruch 14, **dadurch gekennzeichnet, daß** die ursprünglich vorgegebenen Sollwert-Profile normierte Sollwert-Profile sind, die auf der Grundlage von zuvor optimierten Sollwert-Profilen berechnet wurden.

## Claims

1. Method for optimising target value profiles of a plurality of controllable heating elements for thermal treatment of substrates, in which the substrate is heated by way of a plurality of separately controllable heating elements, for each of which a respective target value profile is preset, comprising the following method steps:
a. heating of the heating elements by way of respective predetermined target value profiles;
b. locally triggered measuring of the temperature of the surface, which is remote from the heating elements, of the substrate during a thermal treatment process;
c. ascertaining temperature inhomogeneities occurring on the substrate surface;
d. determining new target value profiles on the basis of the ascertained temperature inhomogeneities; and
e. provision of the new target value profiles for succeeding treatment processes.

2. Method according to claim 1, **characterised in that** a temperature inhomogeneity occurring during the thermal treatment is taken into consideration in advance in terms of time when the target value profiles are determined.

3. Method according to claim 1 or 2, **characterised in that** the temperature of the substrate surface is ascertained at predetermined surface points.

4. Method according to claim 3, **characterised in that** the mean value of all temperature measurement values from the surface points is allocated to a surface region associated with the surface point.

5. Method according to claim 3 or 4, **characterised in that** the association of the surface regions with the surface points remains constant during at least one measuring cycle.

6. Method according to one of claims 3 to 5, **characterised in that** the determination of the new target value profile is carried out on the basis of a weighted association of the individual surface points with the heating elements.

7. Method according to claim 6, **characterised in that** the weighted association remains constant during at least one measuring cycle.

8. Method according to claim 6 or 7, **characterised in that** the weighted association is changed when the new target value profile is determined.

9. Method according to one of the preceding claims, **characterised in that** the time intervals for target value changes are reselected when the new target value profiles are determined.

10. Method according to one of the preceding claims, **characterised in that** a new determination of the target value profile is carried out only when temperature inhomogeneities above a predetermined threshold value arise.

11. Method according to one of the preceding claims, **characterised in that** the substrate during the thermal treatment rests on a plate arranged between the heating elements and the substrate.

12. Method according to one of the preceding claims, **characterised in that** standardised target value profiles calculated from an optimised target value profile are used as original target value profiles.

13. Method for optimisation of target value profiles of a plurality of separately controllable heating elements according to claim 1, **characterised by** repetition of steps a to e until the temperature inhomogeneities at every point in time of the heating lie below a predetermined threshold value.

14. Method according to claim 13, **characterised in that** the optimisation is carried out for different substrates and different end temperatures of the thermal treatment.

15. Method according to claim 14, **characterised in that** the original preset target value profiles are standardised target value profiles calculated on the basis of previously optimised target value profiles.

## Revendications

1. Procédé pour optimiser des profils de valeurs de consigne d'une multitude d'éléments chauffants pouvant être commandés pour le traitement thermique de substrats, où le substrat est chauffé par une multitude d'éléments chauffants pouvant être commandés séparément, auxquels est attribué à chaque fois un profil de valeur de consigne, comprenant les étapes de procédé suivantes:
a) échauffement des éléments chauffants à l'aide de profils de valeurs de consigne à chaque fois prédéfinis;
b) mesure à définition locale de la température de la surface du substrat éloignée des éléments chauffants pendant une opération de traitement thermique;
c) détermination de non-homogénéités de températures se produisant sur la surface du substrat;
d) détermination de nouveaux profils de valeur de consigne sur la base des non-homogénéités de température déterminées; et
e) mise à disposition des nouveaux profils de valeurs de consigne pour les opérations de traitement suivantes.

2. Procédé selon la revendication 1, **caractérisé en ce qu'**une non-homogénéité de température se produisant pendant le traitement thermique est prise en considération lors de la détermination des profils de valeurs de consigne avec une avance dans le temps.

3. Procédé selon la revendication 1 ou 2, **caractérisé en ce que** la température de la surface du substrat est déterminée à des points de surface prédéfinis.

4. Procédé selon la revendication 3, **caractérisé en ce qu'**est attribuée aux points de surface la valeur moyenne de toutes les valeurs de mesure de température à partir d'une zone de surface associée au point de surface.

5. Procédé selon la revendication 3 ou 4, **caractérisé en ce que** l'attribution des zones de surface aux points de surface reste constante pendant au moins un cycle de mesure.

6. Procédé selon l'une des revendications 3 à 5, **caractérisé en ce que** la détermination du nouveau profil de valeur de consigne a lieu à l'aide d'une attribution pondérée des points de surface individuels aux éléments chauffants.

7. Procédé selon la revendication 6, **caractérisé en ce que** l'attribution pondérée reste constante pendant au moins un cycle de mesure.

8. Procédé selon la revendication 6 ou 7, **caractérisé en ce que** l'attribution pondérée est modifiée lors de la définition du nouveau profil de valeur de consigne.

9. Procédé selon l'une des revendications précédentes, **caractérisé en ce que** lors de la définition des nouveaux profils de valeurs de consigne, les intervalles de temps pour les modifications des valeurs de consigne sont sélectionnés nouvellement.

10. Procédé selon l'une des revendications précédentes, **caractérisé en ce qu'**une nouvelle définition du profil de valeurs de consigne a lieu seulement lorsqu'il y a des non-homogénéités de température au-delà d'une valeur de seuil prédéfinie.

11. Procédé selon l'une des revendications précédentes, **caractérisé en ce que** le substrat, pendant le traitement thermique, repose sur une plaque disposée entre les éléments chauffants et le substrat.

12. Procédé selon l'une des revendications précédentes, **caractérisé en ce que** sont utilisés comme profils de valeurs de consigne initiaux des profils de valeurs de consigne normalisés qui ont été calculés à partir d'un profil de valeur de consigne optimisé.

13. Procédé pour optimiser des profils de valeurs de consigne d'une multitude d'éléments chauffants pouvant être commandés séparément pour le traitement thermique de substrats selon la revendication 1, **caractérisé par** les étapes de procédé suivantes:
la répétition des étapes a) à e) jusqu'à ce que les non-homogénéités de température se situent à chaque instant de l'échauffement en dessous d'une valeur de seuil prédéfinie.

14. Procédé selon la revendication 13, **caractérisé en ce que** l'optimisation est effectuée pour des substrats différents et des températures finales différentes du traitement thermique.

15. Procédé selon la revendication 14, **caractérisé en ce que** les profils de valeurs de consigne prédéfinis initialement sont des profils de valeurs de consigne normalisés qui ont été calculés sur la base des profils de valeurs de consigne optimisés préalablement.
